# EUROPEAN PATENT APPLICATION

(11) **EP 3 979 310 A1**
(43) Date of publication of application: **06.04.2022**
(21) Application number: 20815265.2
(22) Date of filing: 22.05.2020
(51) Int. Cl.: H01L 23/29, H01L 23/31, C08L 101/00, C08K 3/01

(54) **RESIN COMPOSITION FOR INSERT MOLDING, SEALING BODY FOR ELECTRONIC COMPONENT, AND METHOD FOR PRODUCING SEALING BODY FOR ELECTRONIC COMPONENT**

(30) Priority: 30.05.2019 JP 2019101328
(71) Applicant: TOYOBO CO., LTD., Osaka-shi Osaka 530-8230 (JP)
(72) Inventor: HAMASAKI, Ryou, Otsu-shi, Shiga 520-0292 (JP)
(74) Representative: Müller-Boré & Partner Patentanwälte PartG mbB
(86) International application number: PCT/JP2020/020230
(87) International publication number: WO 2020/241468

(57) **Abstract**

The purpose of the present invention is to provide an electronic component-sealing product that includes an electromagnetic wave-shielding layer having excellent durability to external environmental factors; a resin composition for obtaining the electromagnetic wave-shielding layer; and a method for manufacturing the electronic component-sealing product. The insert molding resin composition includes a resin and an electromagnetic wave-shielding filler.

## Description

### TECHNICAL FIELD

The present invention relates to an insert molding resin composition, an electronic component-sealing product, and a method for manufacturing the electronic component-sealing product.

### BACKGROUND ART

In recently years, electronic devices such as a personal computer and a mobile phone include an electronic component-mounted substrate obtained by fitting, on a substrate, electronic components such as a semiconductor element, a capacitor, and a coil. These electronic components are sometimes adversely affected by external environmental factors such as water, humidity, and dust, thus have been sealed with a resin to be protected from the external environmental factors. Further, in order to protect the electronic components from an adverse effect of electromagnetic waves, an electromagnetic wave-shielding property has sometimes been imparted to the sealing material.

For example, Patent Document 1 discloses a sealing film that is used to seal an electronic component-mounted substrate including a substrate and an electronic component mounted on one surface side of the substrate and that includes an insulating layer and an electromagnetic wave-shielding layer stacked on one surface side of the insulating layer.

### RELATED ART DOCUMENT

### PATENT DOCUMENT

Patent Document 1: JP-A-2019-21757

### SUMMARY OF THE INVENTION

### PROBLEMS TO BE SOLVED BY THE INVENTION

In the electronic component-mounted substrate sealed with the sealing film of Patent Document 1, the electromagnetic wave-shielding layer is formed on a front surface side of the sealing portion, thus had a possibility of being deteriorated when contacting with external environmental factors. The present invention has been made by focusing on this problem, and an object of the present invention is to provide: an electronic component-sealing product that includes an electromagnetic wave-shielding layer having excellent durability to external environmental factors; and a resin composition for obtaining the electromagnetic wave-shielding layer. Another object of the present invention is to provide a method for manufacturing the electronic component-sealing product.

### SOLUTIONS TO THE PROBLEMS

The insert molding resin composition, the electronic component-sealing product, and the method for manufacturing an electronic component-sealing product, which have solved the problem and are according to the present invention, have the following configurations.
[1] An insert molding resin composition including a resin and an electromagnetic wave-shielding filler.
[2] The insert molding resin composition according to above [1], wherein the resin is a thermoplastic resin.
[3] The insert molding resin composition according to above [1], wherein the resin is a thermosetting resin.
[4] The insert molding resin composition according to any one of above [1] to [3], wherein the resin has a number average molecular weight of 60,000 or less.
[5] An electronic component-sealing product including an electronic component, wherein
   the electronic component is sealed with a resin molded body that includes an electromagnetic wave-shielding layer, the layer being formed of the insert molding resin composition according to any one of above [1] to [4] and formed on a surface of the electronic component, and
   in a section of the resin molded body along a vertical direction to the surface of the electronic component, a number A of particles of the electromagnetic wave-shielding filler per 200 µm square (particles/40,000 µm²) in a region nearer to the surface of the electronic component is larger than a number B of particles of the electromagnetic wave-shielding filler per 200 µm square (particles/40,000 µm²) in a region nearer to a surface of the resin molded body.
[6] The electronic component-sealing product according to above [5], wherein the electromagnetic wave-shielding layer is formed directly on the surface of the electronic component.
[7] The electronic component-sealing product according to above [5] or [6], wherein the resin is at least one selected from the group consisting of a thermoplastic resin and a thermosetting resin.
[8] The electronic component-sealing product according to any one of above [5] to [7], wherein the electromagnetic wave-shielding filler is a conductive filler.
[9] The electronic component-sealing product according to any one of above [5] to [8], wherein the electromagnetic wave-shielding filler has an aspect ratio of 1.5 or more.
[10] The electronic component-sealing product according to above [7], wherein the thermoplastic resin is at least one selected from the group consisting of a polyester-based resin, a polyamide-based resin, a polyolefin-based resin, a polycarbonate-based resin, and a polyurethane-based resin.
[11] The electronic component-sealing product according to above [7], wherein the thermosetting resin is at least one selected from the group consisting of an epoxy-based resin, a phenolic resin, an unsaturated polyester-based resin, a diallyl phthalate-based resin, a urethane (meth)acrylate-based resin, and a polyimide-based resin.
[12] A method for manufacturing an electronic component-sealing product, the method including a step of performing insert molding with use of a first resin composition including the insert molding resin composition according to any one of above [1] to [4], to form an electromagnetic wave-shielding layer on a surface of an electronic component.
[13] The method according to above [12], including a step of heating the first resin composition in an injection molding machine to make the first resin composition melted, and keeping the first resin composition stationary for 5 hours or more.
[14] The method according to above [12] or [13], including a step of performing insert molding with use of a second resin composition including a resin and an electromagnetic wave-shielding filler and having a lower concentration of the electromagnetic wave-shielding filler than a concentration of the electromagnetic wave-shielding filler in the first resin composition, to form a protection layer on the electromagnetic wave-shielding layer.

### EFFECTS OF THE INVENTION

According to the present invention, the configurations described above enable provision of: an electronic component-sealing product that includes an electromagnetic wave-shielding layer having excellent durability to external environmental factors; a resin composition for obtaining the electromagnetic wave-shielding layer; and a method for manufacturing an electronic component-sealing product.

### BRIEF DESCRIPTION OF THE DRAWINGS

Fig. 1 is a sectional view of an electronic component-sealing product according to a first embodiment.
Fig. 2 is a sectional view of an electronic component-sealing product according to a second embodiment.
Fig. 3 is a sectional view of an electronic component-sealing product according to a third embodiment.
Fig. 4 is a sectional view of an electronic component-sealing product according to a fourth embodiment.

### MODE FOR CARRYING OUT THE INVENTION

Hereinafter, the present invention is more specifically described on the basis of the following embodiments. The present invention, however, is not limited by the following embodiments but can also be absolutely carried out with appropriate changes to the embodiments within a scope in compliance with the intent described above and below, and all the changes are to be encompassed within a technical scope of the present invention. In each of the drawings, the symbols of members, or the like are sometimes omitted for convenience. In such a case, the description and other drawings are to be referred to. Further, the drawings put priority on contributing to understanding of the features of the present invention, and therefore the dimensions of various members in the drawings are sometimes different from the actual dimensions thereof.

In an electronic component-sealing product according to the present invention, an electronic component is sealed with a resin molded body that includes an electromagnetic wave-shielding layer formed of an insert molding resin composition including a resin and an electromagnetic wave-shielding filler and formed on a surface of the electronic component; and in a section of the resin molded body along a vertical direction to the surface of the electronic component, a number A of particles of the electromagnetic wave-shielding filler per 200 µm square (particles/40,000 µm²) in a region nearer to the surface of the electronic component (hereinafter, sometimes called an inner region) is larger than a number B of particles of the electromagnetic wave-shielding filler per 200 µm square (particles/40,000 µm²) in a region nearer to a surface of the resin molded body (hereinafter, sometimes called an outer region). The inventor of the present invention has conducted an earnest study and as a result found that a part in the electromagnetic wave-shielding layer that is easily deteriorated by the effects of external environmental factors is the electromagnetic wave-shielding filler in the outer region. Consequently, the inventor has found that setting the number density of the electromagnetic wave-shielding filler to smaller in the outer region than in the inner region of the resin molded body can easily prevent the deterioration of the electromagnetic wave-shielding layer caused by the external environmental factors.

Further, in the electronic component-sealing product according to the present invention, the electromagnetic wave-shielding layer is preferably formed directly on the surface of the electronic component with use of the insert molding resin composition. That is, not providing a insulating layer disclosed in Patent Document 1, between an electronic component and an electromagnetic wave-shielding layer, can easily reduce the thickness and the weight of the sealing portion. As a result, in sealing of an electronic component that is often required of, for example, reducing the weight of the sealing portion or making the sealing portion compact, it is possible to provide a protection layer or the like for the electromagnetic wave-shielding layer on the outer side of the shielding portion without excessively increasing the thickness and the weight of the sealing portion.

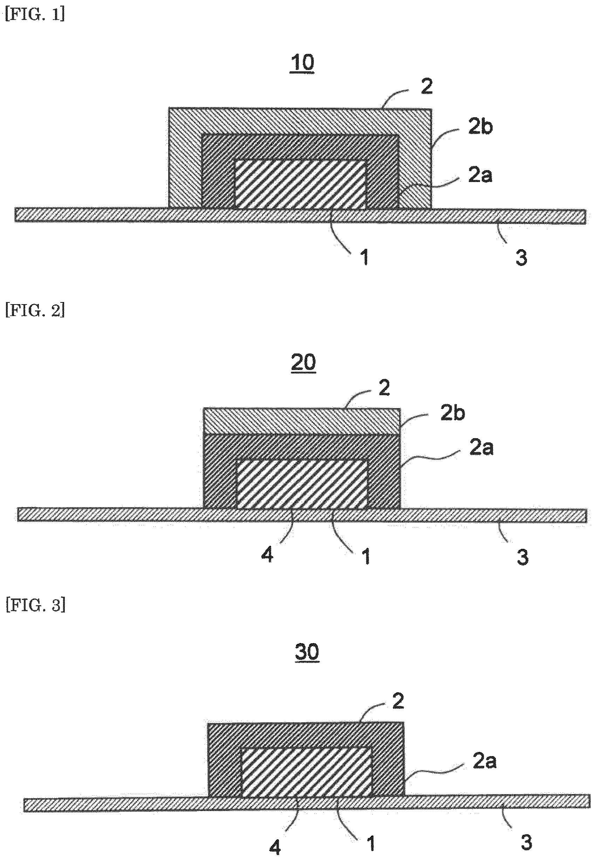

Hereinafter, electronic component-sealing products according to first to fourth embodiments of the present invention are described with reference to Figs. 1 to 4. In the drawings, the members that are assigned with an identical symbol represent the same element, and are not described as appropriate.

Fig. 1 is a sectional view, along the vertical direction to a surface of an electronic component, of an electronic component-sealing product according to a first embodiment.

As illustrated in Fig. 1, an electronic component-sealing product 10 includes an electronic component 1. The electronic component 1 is fitted on a substrate 3, and an electromagnetic wave-shielding layer 2a is formed directly on a surface of the electronic component 1. Further, a protection layer 2b is formed on a surface of the electromagnetic wave-shielding layer 2a. Thus, the electronic component 1 is sealed with a resin molded body 2 including the electromagnetic wave-shielding layer 2a and the protection layer 2b. Meanwhile, the electronic component 1 does not necessarily have to be fitted on the substrate 3, as in an electronic component-sealing product according to a fourth embodiment described later.

Examples of the electronic component 1 include semiconductor elements (e.g., a transistor), a capacitor, a coil, and a resistor. When a conductive portion, a semiconductor portion, or the like of the electronic component 1 is packaged with a resin or a metal, the surface of the electronic component 1 corresponds to a surface of the package.

The electromagnetic wave-shielding layer 2a is positioned in a region (inner region) nearer to the surface of the electronic component 1 in the resin molded body 2, and is formed of an insert molding resin composition including a resin and an electromagnetic wave-shielding filler. The inner region can also be said to be a region positioned on the side of the surface of the electronic component 1 rather than a virtual surface positioned intermediately between the surface of the electronic component 1 and the surface of the resin molded body 2.

The protection layer 2b is positioned in a region (outer region) nearer to the surface of the resin molded body 2 in the resin molded body 2, and is formed of an insert molding resin composition including a resin and an electromagnetic wave-shielding filler. The outer region can also be said to be a region positioned on the side of the surface of the resin molded body 2 rather than the virtual surface positioned intermediately between the surface of the electronic component 1 and the surface of the resin molded body 2. Further, a content of the electromagnetic wave-shielding filler in the protection layer 2b is smaller than a content of the electromagnetic wave-shielding filler in the electromagnetic wave-shielding layer 2a.

That is, a number A of particles of the electromagnetic wave-shielding filler per 200 µm square (particles/40,000 µm²) in the inner region is larger than a number B of particles of the electromagnetic wave-shielding filler per 200 µm square (particles/40,000 µm²) in the outer region. Such a setting allows the electromagnetic wave-shielding layer 2a to shield electromagnetic waves while enabling the protection layer 2b to protect the electromagnetic wave-shielding layer 2a from external environmental factors. Further, making the protection layer 2b contain the electromagnetic wave-shielding filler can also improve the electromagnetic wave-shielding property of the resin molded body 2. Specifically, the number A (particles/40,000 µm²) is preferably 1.01 times or more, more preferably 1.03 times or more, further preferably 1.05 times or more, particularly preferably 1.1 times or more of the number B (particles/40,000 µm²). On the other hand, the number A (particles/40,000 µm²) is preferably 10 times or less of the number B (particles/40,000 µm²). Such a setting allows the resin molded body 2 to easily reduce distortion and the like during, for example, thermal expansion. For this reason, the number A (particles/40,000 µm²) is more preferably 5 times or less, further preferably 2 times or less of the number B (particles/40,000 µm²). Meanwhile, the protection layer 2b does not necessarily have to contain the electromagnetic wave-shielding filler. The number of particles of the electromagnetic wave-shielding filler can be measured by a known method using an electron microscope or the like. Further, when the number of particles of the electromagnetic wave-shielding filler is counted, a filler particle having a major axis of less than 0.5 µm is not counted, because its electromagnetic wave-shielding property is weak.

A total area A (µm²) of the electromagnetic wave-shielding filler per 200 µm square (40,000 µm²) in the inner region is preferably larger than a total area B (µm²) of the electromagnetic wave-shielding filler per 200 µm square (40,000 µm²) in the outer region. Setting the total area of the electromagnetic wave-shielding filler to smaller in the outer region than in the inner region of the resin molded body can easily prevent deterioration of the electromagnetic wave-shielding layer caused by external environmental factors.

The total area A (µm²) is preferably 1.01 times or more, more preferably 1.03 times or more, further preferably 1.05 times or more, particularly preferably 1.1 times or more of the total area B (µm²). On the other hand, the total area A (µm²) is preferably 10 times or less of the total area B (µm²). Such a setting allows the resin molded body 2 to easily reduce distortion and the like during, for example, thermal expansion. For this reason, the total area A (µm²) is more preferably 5 times or less, further preferably 2 times or less of the total area B (µm²).

The 200 µm square region in the inner region is preferably selected from a region within 1.0 mm, more preferably within 500 µm from the surface of the electronic component 1. On the other hand, the 200 µm square region in the outer region is preferably selected from a region within 1.0 mm, more preferably within 500 µm from the surface of the resin molded body 2.

The 200 µm square region in the inner region is preferably selected from a region within 10%, more preferably within 5% from the surface of the electronic component 1, with respect to the height of the section of the resin molded body 2 along the vertical direction to the surface of the electronic component 1. On the other hand, the 200 µm square region in the outer region is preferably selected from a region within 10%, preferably within 5% from the surface of the resin molded body 2.

The electromagnetic wave-shielding filler contained in the electromagnetic wave-shielding layer 2a is a material capable of exhibiting the electromagnetic wave-shielding property by, for example, reflecting or absorbing electromagnetic waves.

The electromagnetic wave-shielding filler is preferably a conductive filler. The conductive filler having conductivity can easily increase the reflection loss or the absorption loss of electromagnetic waves.

The electromagnetic wave-shielding filler preferably has a volume resistivity of 1 Ω·cm or less. Such a setting easily makes the electromagnetic wave-shielding filler conductive, and the electromagnetic wave-shielding filler more easily exhibits the electromagnetic wave-shielding property as it has a lower volume resistivity. For this reason, the electromagnetic wave-shielding filler has a volume resistivity of more preferably 10⁻³ Ω·cm or less, further preferably 10⁻⁵ Ω·cm or less, further more preferably 10⁻⁶ Ω·cm or less, particularly preferably 10⁻⁷ Ω·cm or less.

Examples of the electromagnetic wave-shielding filler include a metal-based filler, a metal compound-based filler, and a carbon-based filler. Alternatively, as the electromagnetic wave-shielding filler, a magnetic filler having conductivity, and a metal-plated material obtained by coating glass beads, fibers, or the like with a metal or the like may also be used. Further, a metal-based filler, a metal compound-based filler, a carbon-based filler, a magnetic filler, and a material obtained by coating glass beads, fibers, or the like with silica or the like may also be used. These fillers may be used alone or in combination of two or more thereof.

Examples of the metal-based filler include aluminum, zinc, iron, silver, copper, nickel, stainless steel, and palladium. These fillers may be used alone or in combination of two or more thereof.

Examples of the metal compound-based filler include a zinc-oxide-based filler, a barium sulfate-based filler, an aluminum borate-based filler, a titanium oxide-based filler, a titan black-based filler, a tin oxide-based filler, an indium oxide-based filler, a potassium titanate-based filler, and a lead zirconate titanate-based filler. These fillers may be used alone or in combination of two or more thereof.

Examples of the carbon-based filler include acetylene black, ketjen black, furnace black, carbon black, a carbon fiber, a carbon nanotube, a carbon microcoil. These fillers may be used alone or in combination of two or more thereof.

A magnetic filler is capable of having a magnetic property and absorbing and thus reducing electromagnetic waves. Specific examples of the magnetic filler include ferrite-based fillers such as Mn ferrite, Ni ferrite, Zn ferrite, Ba ferrite, Sr ferrite, Mn-Zn ferrite, and Ni-Zn ferrite; silicon atom-containing iron-based fillers such as an iron-aluminum-silicon alloy; nickel-iron-based alloy-based fillers such as a nickel-manganese-iron alloy, a nickel-molybdenum-copper-iron alloy, and a nickel-molybdenum-manganese-iron alloy; an iron-cobalt-based alloy-based filler; and a neodymium-iron-boron alloy-based filler. Among these examples, a strongly magnetic material that exhibits ferromagnetism or ferrimagnetism is preferable.

Other examples of the electromagnetic wave-shielding filler include a magnetic filler having no conductivity.

The electromagnetic wave-shielding filler is not particularly limited in terms of the shape, but is preferably at least one selected from the group consisting of a spherical filler, a needle-like filler, a rod-like filler, a fibrous filler, a flattened filler, a scale-like filler, and a plate-like filler. Among these examples, at least one selected from the group consisting of a needle-like filler, a rod-like filler, a fibrous filler, a flattened filler, a scale-like filler, and a plate-like filler is more preferable because it easily improves the conductivity. In addition, the use of a spherical filler enables the electromagnetic wave-shielding layer 2a to reduce localized stress concentration and to further easily reduce distortion during thermal expansion. For this reason, combining, with a spherical filler, at least one selected from the group consisting of a needle-like filler, a rod-like filler, a fibrous filler, a flattened filler, a scale-like filler, and a plate-like filler is effective in cases where not only the electromagnetic wave-shielding property but also heat resistance or the like is required.

The electromagnetic wave-shielding filler preferably has an aspect ratio of 1.5 or more. The electromagnetic wave-shielding filler having an aspect ratio of 1.5 or more easily improves the electromagnetic wave-shielding property. For this reason, the electromagnetic wave-shielding filler has an aspect ratio of more preferably 3 or more, further preferably 5 or more, further more preferably 10 or more. On the other hand, the electromagnetic wave-shielding filler having an aspect ratio of 60 or less allows the electromagnetic wave-shielding layer 2a to easily reduce localized stress concentration and distortion during thermal expansion. For this reason, the electromagnetic wave-shielding filler has an aspect ratio of preferably 60 or less, more preferably 40 or less, further preferably 30 or less.

The electromagnetic wave-shielding layer 2a may include an electromagnetic wave-shielding filler having an aspect ratio of 1.5 or more and an electromagnetic wave-shielding filler having an aspect ratio of less than 1.5. In this case, the electromagnetic wave-shielding layer 2a preferably has a number ratio of the electromagnetic wave-shielding filler having an aspect ratio of 1.5 or more to the electromagnetic wave-shielding filler having an aspect ratio of less than 1.5 of 10% or more and 90% or less. The electromagnetic wave-shielding layer 2a having a number ratio of 10% or more easily improves the conductivity. For this reason, the electromagnetic wave-shielding layer 2a has a number ratio of more preferably 30% or more, further preferably 40% or more. On the other hand, the electromagnetic wave-shielding layer 2a having a number ratio of 90% or less easily reduces localized stress concentration and distortion during thermal expansion. For this reason, the electromagnetic wave-shielding layer 2a has a number ratio of more preferably 70% or less, further preferably 60% or less.

The electromagnetic wave-shielding filler preferably has a major axis of 0.5 µm or more. The electromagnetic wave-shielding filler having a major axis of 0.5 µm or more easily improves the electromagnetic wave-shielding property. For this reason, the electromagnetic wave-shielding filler has a major axis of more preferably 1.0 µm or more, further preferably 2.0 µm or more, further more preferably 5.0 µm or more. On the other hand, the upper limit of the major axis of the electromagnetic wave-shielding filler is not particularly limited, and the upper limit may be, for example, 500 µm or less, 300 µm or less, 100 µm or less, 50 µm or less, or 30 µm or less.

The electromagnetic wave-shielding layer 2a may include an electromagnetic wave-shielding filler having a major axis of 0.5 µm or more and an electromagnetic wave-shielding filler having a major axis of less than 0.5 µm. In this case, the electromagnetic wave-shielding layer 2a preferably has a number ratio of the electromagnetic wave-shielding filler having a major axis of 0.5 µm or more to the electromagnetic wave-shielding filler having a major axis of less than 0.5 µm of 10% or more and 90% or less. The electromagnetic wave-shielding layer 2a having a number ratio of 10% or more easily improves the conductivity. For this reason, the electromagnetic wave-shielding layer 2a has a number ratio of more preferably 30% or more, further preferably 40% or more. On the other hand, the electromagnetic wave-shielding layer 2a having a number ratio of 90% or less easily reduces localized stress concentration and distortion during thermal expansion. For this reason, the electromagnetic wave-shielding layer 2a has a number ratio of more preferably 70% or less, further preferably 60% or less.

The electromagnetic wave-shielding layer 2a has, relative to 100 parts by mass of the resin, a content of the electromagnetic wave-shielding filler of preferably 3 parts by mass or more and 1000 parts by mass or less. The electromagnetic wave-shielding layer 2a having a ratio of the electromagnetic wave-shielding filler of 3 parts by mass or more easily improves the electromagnetic wave-shielding property. For this reason, the electromagnetic wave-shielding layer 2a has a ratio of the electromagnetic wave-shielding filler of more preferably 5 parts by mass or more, further preferably 10 parts by mass or more, further more preferably 15 parts by mass or more. On the other hand, the electromagnetic wave-shielding layer 2a having a ratio of the electromagnetic wave-shielding filler of 1000 parts by mass or less easily improves the adhesiveness. For this reason, the electromagnetic wave-shielding layer 2a has a ratio of the electromagnetic wave-shielding filler of more preferably 800 parts by mass or less, further preferably 300 parts by mass or less, further more preferably 100 parts by mass or less.

As to the resin included in the electromagnetic wave-shielding layer 2a, the description below of the resin included in the insert molding resin composition according to the present invention can be referred to.

As to the material, the shape, the aspect ratio, the major axis, and the like of the electromagnetic wave-shielding filler included in the protection layer 2b, the electromagnetic wave-shielding filler included in the electromagnetic wave-shielding layer 2a can be referred to.

The protection layer 2b has, relative to 100 parts by mass of the resin, a content of the electromagnetic wave-shielding filler of preferably 1 part by mass or more and 950 parts by mass or less. The protection layer 2b having a ratio of the electromagnetic wave-shielding filler of 1 part by mass or more easily improves the electromagnetic wave-shielding property. For this reason, the protection layer 2b has a ratio of the electromagnetic wave-shielding filler of more preferably 3 parts by mass or more, further preferably 5 parts by mass or more, further more preferably 10 parts by mass or more. On the other hand, the protection layer 2b having a ratio of the electromagnetic wave-shielding filler of 950 parts by mass or less easily improves the adhesiveness. For this reason, the protection layer 2b has a ratio of the electromagnetic wave-shielding filler of more preferably 750 parts by mass or less, further preferably 250 parts by mass or less, further more preferably 90 parts by mass or less. Meanwhile, the protection layer 2b does not necessarily have to include the electromagnetic wave-shielding filler.

As to the resin included in the protection layer 2b, the resin described in the explanation below of the insert molding resin composition according to the present invention may be referred to. Meanwhile, the resin included in the protection layer 2b is preferably the same resin as the resin included in the electromagnetic wave-shielding layer 2a.

The outer shape of the resin molded body 2 is not particularly limited and may be provided with a recess or a projection as necessary. The resin molded body 2 is not limited to including one layer but may include two or more layers as the electromagnetic wave-shielding layer 2a. In addition, the resin molded body 2 is not limited to including one layer but may include two or more layers as the protection layer 2b.

Sealing of the electronic component 1 with the resin molded body 2 can be performed by, for example, the following method. First, insert molding is performed for the electronic component 1 fitted on the substrate 3, with use of a molding resin composition including a resin and an electromagnetic wave-shielding filler, to form the electromagnetic wave-shielding layer 2a. Further, insert molding is performed with use of a molding resin composition having a lower content of the electromagnetic wave-shielding filler, to form the protection layer 2b. Thus, the electronic component 1 can be sealed with the resin molded body 2.

Examples of the substrate 3 include a resin substrate, a glass epoxy substrate, a tin-plated copper substrate, a nickel-plated copper substrate, a SUS substrate, and an aluminum substrate. The resin substrate is preferably a substrate formed of an insulating resin.

Next, an electronic component-sealing product according to a second embodiment of the present invention is described with reference to Fig. 2. Fig. 2 is a sectional view, along the vertical direction to a surface of an electronic component, of the electronic component-sealing product according to the second embodiment.

As illustrated in Fig. 2, an electronic component 1 in an electronic component-sealing product 20 has an electromagnetic wave-shielding layer 2a formed directly on a surface thereof. Further, a protection layer 2b is provided on a surface (hereinafter, sometimes called an upper surface) of the electromagnetic wave-shielding layer 2a that is opposite from a fitting portion 4 of the electronic component 1. Thus, the protection layer 2b may be formed in a part of the surface of the electromagnetic wave-shielding layer 2a. The electromagnetic wave-shielding layer 2a is, at the upper surface thereof, particularly susceptible to the effects of external environmental factors and therefore, preferably has at least the upper surface thereof protected by the protection layer 2b.

Next, an electronic component-sealing product according to a third embodiment of the present invention is described with reference to Fig. 3. Fig. 3 is a sectional view, along the vertical direction to a surface of an electronic component, of the electronic component-sealing product according to the third embodiment.

As illustrated in Fig. 3, an electronic component 1 in an electronic component-sealing product 30 has an electromagnetic wave-shielding layer 2a formed directly on a surface thereof.

In the electromagnetic wave-shielding layer 2a, a region (inner region) positioned on the side of the surface of the electronic component 1 rather than a virtual surface positioned intermediately between the surface of the electronic component 1 and a surface of a resin molded body 2 (electromagnetic wave-shielding layer 2a) has a larger content of the electromagnetic wave-shielding filler than the content of the electromagnetic wave-shielding filler in an (outer region) positioned on the side of the surface of the resin molded body 2 (electromagnetic wave-shielding layer 2a) rather than the virtual surface. Specifically, the electromagnetic wave-shielding layer 2a has a concentration inclination structure formed so as to increase the content of the electromagnetic wave-shielding filler toward the inner side thereof. The electromagnetic wave-shielding layer 2a having such a structure has a higher electromagnetic wave-shielding property on the inner side thereof, and because the electromagnetic wave-shielding layer 2a has a lower content of the electromagnetic wave-shielding filler on the outer side thereof, it easily prevents deterioration caused by contact with external environmental factors.

The concentration inclination structure can be formed, for example, by keeping, in insert molding, a resin composition stationary in a plasticized state (melted state) for a long time in an injection molding machine, and next performing injection molding while keeping the state. The stationary keeping time is, for example, 5 hours or more.

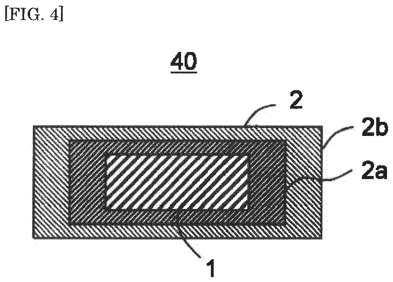

Next, an electronic component-sealing product according to a fourth embodiment of the present invention is described with reference to Fig. 4. Fig. 4 is a sectional view, along the vertical direction to a surface of an electronic component, of the electronic component-sealing product according to the fourth embodiment.

As illustrated in Fig. 4, an electronic component 1 in an electronic component-sealing product 40 has an electromagnetic wave-shielding layer 2a formed directly on a surface thereof. Further, a protection layer 2b is formed on a surface of the electromagnetic wave-shielding layer 2a. Thus, the electronic component 1 is sealed with a resin molded body 2 including the electromagnetic wave-shielding layer 2a and the protection layer 2b. As in the electronic component-sealing product 40, the electronic component 1 does not necessarily have to be fitted on a substrate.

The present invention also includes a resin composition for obtaining the electromagnetic wave-shielding layer of these electronic component-sealing products. Specifically, the resin composition according to the present invention is an insert molding resin composition including a resin and an electromagnetic wave-shielding filler. Forming the electromagnetic wave-shielding layer directly on the surface of the electronic component with use of the insert molding resin composition makes it less likely to generate a gap between the electronic component and the electromagnetic wave-shielding layer. Further, not providing, in insert molding, the insulating layer disclosed in Patent Document 1, between the electronic component and the electromagnetic wave-shielding layer can easily reduce the thickness and the weight of the sealing portion, and therefore a protection layer or the like for the electromagnetic wave-shielding layer can easily be provided on the outer side of the sealing portion without excessively increasing the thickness and the weight of the sealing portion.

As to the electromagnetic wave-shielding filler included in the insert molding resin composition, the electromagnetic wave-shielding filler included in the electromagnetic wave-shielding layer 2a of the electronic component-sealing product according to the first embodiment can be referred to.

The resin included in the insert molding resin composition is preferably at least one selected from the group consisting of a thermoplastic resin and a thermosetting resin.

The thermoplastic resin is preferably at least one selected from the group consisting of a polyester-based resin, a polyamide-based resin, a polyolefin-based resin, a polycarbonate-based resin, and a polyurethane-based resin. Among these examples, a polyester-based resin is more preferable.

Examples of the polyester-based resin include a resin formed through a reaction of a carboxylic acid component with a hydroxyl group component. Examples of the carboxylic acid component include terephthalic acid, isophthalic acid, adipic acid, azelaic acid, sebacic acid, 1,4-cyclohexanedicarboxylic acid, 1,3-cyclohexanedicarboxylic acid, 1,2-cyclohexanedicarboxylic acid, 4-methyl-1,2-cyclohexanedicarboxylic acid, a dimer acid, a hydrogenated dimer acid, and a naphthalene dicarboxylic acid. Examples of the hydroxyl group component include ethylene glycol, 1,2-propanediol, 1,3-propanediol, 1,2-butanediol, 1,3-butanediol, 1,4-butanediol, 2-methyl-1,3-propaneidol, 1,5-pentanediol, 1,6-hexanediol, 3-methyl-1,5-pentanediol, dipropylene glycol, diethylene glycol, neopentyl glycol, 2,2,4-trimethyl- 1,3-pentanediol, tricyclodecanedimethanol, neopentylglycol hydroxypivalate ester, 1,9-nonaediol, 2-methyloctanediol, 1,10-dodecanediol, 2-butyl-2-ethyl-1,3-propanediol, polytetramethylene glycol, polyoxymethylene glycol, and cyclohexane dimethanol. These components may be used alone or in combination of two or more thereof. Examples of a commercially available product of the polyester-based resin include crystalline polyester resins GM-950, GM-955, and GM-960 manufactured by

### TOYOBO CO., LTD.

As the polyester-based resin, polyester including a polyalkylene glycol component is preferable. Specifically, the polyester-based resin is preferably formed through ester bonding between a hard segment mainly including a polyester segment and a soft segment mainly including a polyalkylene glycol component.

The polyester-based resin as a whole preferably contains 20 wt% or more and 80 wt% or less, more preferably 30 wt% or more and 70 wt% or less of the hard segment.

The polyester segment in the hard segment preferably includes, as a main component, polyester formed through polycondensation between an aromatic dicarboxylic acid and an aliphatic glycol and/or an alicyclic glycol. The main component means a component contained in an amount of 80 wt% or more, more preferably 90 wt% or more in the polyester segment.

As the aromatic dicarboxylic acid, an aromatic dicarboxylic acid having 8 to 14 carbon atoms is preferable because it can improve the heat resistance of the polyester-based resin, and terephthalic acid and/or naphthalene dicarboxylic acid is more preferable because it is easily reacted with a glycol.

The aliphatic glycol and/or the alicyclic glycol is an alkylene glycol having preferably 2 to 10 carbon atoms, more preferably 2 to 8 carbon atoms. The aliphatic glycol and/or the alicyclic glycol is contained at a proportion of preferably 50 mol% or more, more preferably 70 mol% or more in the whole glycol component. As the glycol component, ethylene glycol, 1,3-propylene glycol, 1,4-butanediol, 1,6-hexanediol, 1,4-cyclohexanedimethanol, and the like are preferable, and 1,4-butanediol and 1,4-cyclohexanedimethanol are more preferable because they easily improve the heat resistance of polyester.

The polyester-based resin as a whole preferably contains 20 wt% or more and 80 wt% or less, more preferably 30 wt% or more and 70 wt% or less of the soft segment.

The polyalkylene glycol component in the soft segment is preferably polyethylene glycol, polytrimethylene glycol, polytetramethylene glycol, or the like, and is more preferably polytetramethylene glycol in terms of an improvement of softness of the polyester-based resin and a capability of lowering the melt viscosity of the polyester-based resin.

The soft segment is preferably made from mainly the polyalkylene glycol component. With the whole glycol component constituting the polyester-based resin defined as 100 mol%, the copolymerization ratio of the soft segment is preferably 1 mol% or more, more preferably 5 mol% or more, further preferably 10 mol% or more, particularly preferably 20 mol% or more. Such a setting increases the melt viscosity of the polyester-based resin, enabling sealing at low pressure. On the other hand, the copolymerization ratio of the soft segment is preferably 90 mol% or less, more preferably 55 mol% or less, further preferably 50 mol% or less, particularly preferably 45 mol% or less. Such a setting easily improves the heat resistance of the polyester resin.

The soft segment has a number average molecular weight of preferably 400 or more, more preferably 800 or more. Such a setting can easily impart the softness to the polyester-based resin. On the other hand, the soft segment has a number average molecular weight of preferably 5000 or less, more preferably 3000 or less. Such a setting enables the soft segment to be easily copolymerized with another copolymerization component.

The polyester-based resin has a number average molecular weight of preferably 3,000 or more, more preferably 5,000 or more, further preferably 7,000 or more. Such a setting can easily improve the hydrolysis resistance of the resin composition and the strength elongation of the resin molded body in high temperature and high humidity. On the other hand, the upper limit of the number average molecular weight of the polyester-based resin is preferably 60,000 or less, more preferably 50,000 or less, further preferably 40,000 or less. Such a setting easily reduces the melt viscosity of the polyester-based resin, enabling reduction of molding pressure.

The polyester-based resin has a melting point of preferably 70°C or more and 210°C or less, more preferably 100°C or more and 190°C or less.

Examples of the polyamide-based resin include a resin having an amide bond in the molecule thereof. Preferred as the polyamide-based resin is specifically a reaction product of a dimer acid, an aliphatic dicarboxylic acid, an aliphatic compound, an alicyclic compound, and/or a polyether diamine. Specifically, the polyamide-based resin more preferably includes 50 to 98 mol% of a dimer fatty acid, 2 to 50 mol% of a C₆ to C₂₄ aliphatic dicarboxylic acid, 0 to 10 mol% of a C₁₄ to C₂₂ monocarboxylic acid, 0 to 40 mol% of a polyether diamine, and 60 to 100 mol% of an aliphatic diamine. Examples of a commercially available product of the polyamide-based resin include THERMELT 866, 867, 869, and 858 manufactured by Bostik.

Examples of the polyolefin-based resin include homopolymers or copolymers of olefins such as ethylene, propylene, and butene; copolymers of these olefins with a copolymerizable monomer component; and maleic anhydride-modified products of these polymers. Specific examples of the polyolefin-based resin include polyethylene, polypropylene, an ethylenevinyl acetate copolymer, an ethylene-ethyl acrylate copolymer, an ethylene-acrylic acid copolymer, an ethylene-methyl methacrylate copolymer, an ethylene-α-olefin copolymer, an ethylene-propylene copolymer, an ethylene-butene copolymer, and a propylene-butene copolymer. These fillers may be used alone or in combination of two or more thereof.

Examples of the polycarbonate-based resin include a resin obtained through a reaction of a polyfunctional hydroxy compound with a carbonate ester-forming compound. Examples of the polyfunctional hydroxy compound include 4,4'-dihydroxybiphenyl that may have a substituent, and a bis(hydroxyphenyl)alkane that may have a substituent. Examples of the carbonate ester-forming compound include various dihalogenated carbonyls such as phosgene; haloformates such as chloroformate; and carbonate ester compounds such as a bisaryl carbonate.

Examples of the polyurethane-based resin include a resin formed through a reaction of a hydroxyl group component (prepolymer) with an isocyanate compound (curing agent). Examples of the hydroxyl group component include at least one selected from the group consisting of polyester polyol, polycaprolactone polyol, polyether polyol, and a polyalkylene polyol. Examples of the isocyanate compound include at least one diisocyanate selected from the group consisting of trimethylene diisocyanate (TDI), hexamethylene diisocyanate (HDI), diphenylmethane diisocyanate (MDI), isophorone diisocyanate (IPDI), and xylylene diisocyanate (XDI).

The thermosetting resin is preferably at least one selected from the group consisting of an epoxy-based resin, a phenolic resin, an unsaturated polyester-based resin, a diallyl phthalate-based resin, a urethane (meth)acrylate-based resin, and a polyimide-based resin. Among these examples, a urethane (meth)acrylate-based resin or an epoxy-based resin is more preferable.

Examples of the epoxy-based resin include a bisphenol epoxy resin made from bisphenol A, bisphenol F, bisphenol S, or a derivative thereof; a bixylenol epoxy resin made from bixylenol or a derivative thereof; a biphenol epoxy resin made from biphenol or a derivative thereof; a naphthalene epoxy resin made from naphthalene or a derivative thereof, and a novolac epoxy resin. The epoxy-based resin preferably has an epoxy equivalent, which is an index of molecular weight of an epoxy resin, of 174 to 16000 g/eq. These fillers may be used alone or in combination of two or more thereof. The epoxy-based resin is preferably epoxy (meth)acrylate. Examples of epoxy (meth)acrylate include epoxy (meth)acrylate that is obtained through an addition reaction of an epoxy resin having two or more glycidyl ether groups in one molecule with acrylic acid or methacrylic acid and that has a double bond of an acrylate or a methacrylate at a molecular end. The epoxy-based resin may also be an epoxy (meth)acrylate resin obtained by dissolving epoxy (meth)acrylate in a radical polymerizable monomer and/or a radical polymerizable multimer.

As the phenolic resin, various resins having a phenolic residue as a building block can be used, and examples of the phenolic resin include resins formed through reactions of phenolic hydroxyl group-containing phenols such as phenol, cresol, xylenol, a p-alkylphenol, chlorophenol, bisphenol A, phenolsulfonic acid, resorcin, and various modified phenols, with aldehydes such as formalin and furfural.

The unsaturated polyester-based resin is formed through a reaction of an acid component with an alcohol component. Examples of the acid component include unsaturated polybasic acids such as maleic acid, fumaric acid, and itaconic acid and anhydrides thereof; and aromatic carboxylic acids such as phthalic acid, isophthalic acid, and terephthalic acid and anhydrides thereof. Examples of the alcohol component include alkylene glycols such as ethylene glycol, diethylene glycol, and propylene glycol; and aromatic diols such as bisphenol A and a bisphenol A-C₂₋₄ alkylene oxide.

Examples of the diallyl phthalate-based resin include resins obtained from diallyl phthalate monomers such as diallyl phthalate, diallyl isophthalate, diallyl terephthalate, and diallyl orthophthalate.

The urethane (meth)acrylate-based resin can be obtained by reacting a compound having an alcoholic hydroxyl group and a (meth)acrylate group with an isocyanate at a molecular end of a compound, which is obtained through a reaction between a diisocyanate and at least one selected from the group consisting of a polyalcohol, a polyester polyol, and a polyether polyol each having two or more hydroxyl groups in one molecule, and/or with an isocyanate group of a compound having the isocyanate group in one molecule. Alternatively, a compound having a double bond of a (meth)acrylate group at a molecular end can be used as the urethane (meth)acrylate-based resin, the compound being obtained by reacting at least one selected from the group consisting of a polyalcohol, a polyester polyol, and a polyether polyol each having two or more hydroxyl groups in one molecule, with an isocyanate group of a compound obtained through a reaction between a diisocyanate and a compound having an alcoholic hydroxyl group and a (meth)acrylate group so as to allow the isocyanate group to remain.

The polyimide-based resin is a resin having an imide bond in the molecular main chain, and examples of the polyimide-based resin include at least one selected from the group consisting of a condensation polymer of an aromatic diamine or an aromatic diisocyanate with an aromatic tetracarboxylic acid, a bismaleimide resin that is an addition polymer of an aromatic diamine or an aromatic diisocyanate with bismaleimide, a polyaminobismaleimide resin that is an addition polymer of an aminobenzoic acid hydrazide with bismaleimide, and a bismaleimide triazine resin that is made from a dicyanate compound and a bismaleimide resin.

The resin included in the insert molding resin composition is preferably a thermoplastic resin or a thermosetting resin, more preferably a thermoplastic resin or at least one thermosetting resin selected from the group consisting of an unsaturated polyester-based resin, a diallyl phthalate-based resin, a urethane (meth)acrylate-based resin, and a polyimide-based resin, further preferably a thermoplastic resin.

The resin has a number average molecular weight of preferably 3,000 or more, more preferably 5,000 or more, further preferably 7,000 or more. Such a setting can easily improve the hydrolysis resistance of the resin composition and the strength elongation of the resin molded body in high temperature and high humidity. On the other hand, the upper limit of the number average molecular weight of the resin is preferably 60,000 or less, more preferably 50,000 or less, further preferably 40,000 or less. Such a setting easily reduces the melt viscosity of the resin, enabling reduction of molding pressure. Such a setting also enables the electromagnetic wave-shielding filler to easily settle out.

The resin preferably has a melt viscosity at 200°C of 2000 dPa·s or less. The resin having a low melt viscosity allows the electromagnetic wave-shielding filler to easily settle out. The resin has a melt viscosity of more preferably 1500 dPa·s or less, further preferably 1000 dPa·s or less, further more preferably 700 dPa·s or less. On the other hand, setting the melt viscosity to 5 dPa·s or more can easily suppress so-called drooling accompanying leakage of the resin from a nozzle or the like. The resin has a melt viscosity of more preferably 20 dPa·s or more, further preferably 50 dPa·s or more, further more preferably 100 dPa·s or more.

The melt viscosity at 200°C of the resin can be obtained by the following method. Using, for example, a flow tester (CFT-500C) manufactured by SHIMADZU CORPORATION, a resin sample dried to have a moisture percentage of 0.1% or less is charged into a cylinder in the center of a heated body set to 200°C, a load (10 kgf) is applied to the sample via a plunger after a lapse of 1 minute from the charge to extrude the melted sample from a die (pore diameter: 1.0 mm, thickness: 10 mm) at the bottom of the cylinder. The lowering distance and the lowering time of the plunger in the extrusion may be recorded to calculate the melt viscosity.

To the insert molding resin composition, various additives that are usually used in injection molding or the like can be added, in addition to the resin and the electromagnetic wave-shielding filler, without impairing the properties of the resin molded body. Examples of the additives include a flame retardant, a plasticizer, a mold-releasing agent, a hydrolysis inhibitor, a filling agent, an antioxidant, an anti-heat aging agent, a copper inhibitor, an antistatic agent, a light resistance stabilizer, and an ultraviolet absorber. These additives may be used alone or in combination of two or more thereof.

The present invention also includes a method for manufacturing an electronic component-sealing product.

Examples of a method, according to an embodiment of the present invention, for manufacturing an electronic component-sealing product include a manufacturing method including a step of performing insert molding with use of a first resin composition including the insert molding resin composition described above, to form an electromagnetic wave-shielding layer on a surface of an electronic component.

The manufacturing method preferably includes a step of heating the first resin composition in an injection molding machine to make the first resin composition melted, and keeping the first resin composition stationary for 5 hours or more. This step allows the electromagnetic wave-shielding layer to easily form the concentration inclination structure of the electromagnetic wave-shielding filler. The upper limit of the stationary keeping time in the injection molding machine is preferably around 10 hours or less. The stationary keeping temperature is preferably a temperature in the same range as the nozzle temperature below.

The temperature (nozzle temperature) during the injection molding is preferably 100°C or more and 250°C or less. The temperature is more preferably 120°C or more and 220°C or less, further preferably 140°C or more and 210°C or less. The pressure during the injection molding is preferably 50 MPa or less. Setting the injection pressure to 50 MPa or less can suppress deformation of the electronic component. The injection pressure is more preferably 40 MPa or less, further preferably 30 MPa or less, further more preferably 20 MPa or less. On the other hand, the lower limit of the injection pressure is preferably 0.1 MPa or more, more preferably 0.5 MPa or more, further preferably 2 MPa or more, further more preferably 5 MPa or more.

The manufacturing method preferably includes a step of performing insert molding with use of a second resin composition including a resin and an electromagnetic wave-shielding filler and having a lower concentration of the electromagnetic wave-shielding filler than a concentration of the electromagnetic wave-shielding filler in the first resin composition, to form a protection layer on the electromagnetic wave-shielding layer. This step enables the layer formed of the first resin composition having a higher concentration of the electromagnetic wave-shielding filler to be protected by the layer formed of the second resin composition having a lower concentration of the electromagnetic wave-shielding filler.

When the electronic component is sealed with the insert molding resin composition, all the surfaces of the electronic component do not necessarily have to be sealed at the same time, but after one surface of the electronic component is sealed, another surface may be sealed.

The present application claims priority based on Japanese Patent Application No. 2019-101328 filed on May 30, 2019. All the contents described in Japanese Patent Application No. 2019-101328 filed on May 30, 2019 are incorporated herein by reference.

### DESCRIPTION OF REFERENCE SIGNS

1 electronic component
2 resin molded body
2a electromagnetic wave-shielding layer
2b protection layer
3 substrate
4 fitting portion
10 electronic component-sealing product according to first embodiment
20 electronic component-sealing product according to second embodiment
30 electronic component-sealing product according to third embodiment
40 electronic component-sealing product according to fourth embodiment

## Claims

1. An insert molding resin composition comprising a resin and an electromagnetic wave-shielding filler.

2. The insert molding resin composition according to claim 1, wherein the resin is a thermoplastic resin.

3. The insert molding resin composition according to claim 1, wherein the resin is a thermosetting resin.

4. The insert molding resin composition according to any one of claims 1 to 3, wherein the resin has a number average molecular weight of 60,000 or less.

5. An electronic component-sealing product comprising an electronic component, wherein
the electronic component is sealed with a resin molded body that includes an electromagnetic wave-shielding layer, the layer being formed of the insert molding resin composition according to any one of claims 1 to 4 and formed on a surface of the electronic component, and
in a section of the resin molded body along a vertical direction to the surface of the electronic component, a number A of particles of the electromagnetic wave-shielding filler per 200 µm square (particles/40,000 µm²) in a region nearer to the surface of the electronic component is larger than a number B of particles of the electromagnetic wave-shielding filler per 200 µm square (particles/40,000 µm²) in a region nearer to a surface of the resin molded body.

6. The electronic component-sealing product according to claim 5, wherein the electromagnetic wave-shielding layer is formed directly on the surface of the electronic component.

7. The electronic component-sealing product according to claim 5 or 6, wherein the resin is at least one selected from the group consisting of a thermoplastic resin and a thermosetting resin.

8. The electronic component-sealing product according to any one of claims 5 to 7, wherein the electromagnetic wave-shielding filler is a conductive filler.

9. The electronic component-sealing product according to any one of claims 5 to 8, wherein the electromagnetic wave-shielding filler has an aspect ratio of 1.5 or more.

10. The electronic component-sealing product according to claim 7, wherein the thermoplastic resin is at least one selected from the group consisting of a polyester-based resin, a polyamide-based resin, a polyolefin-based resin, a polycarbonate-based resin, and a polyurethane-based resin.

11. The electronic component-sealing product according to claim 7, wherein the thermosetting resin is at least one selected from the group consisting of an epoxy-based resin, a phenolic resin, an unsaturated polyester-based resin, a diallyl phthalate-based resin, a urethane (meth)acrylate-based resin, and a polyimide-based resin.

12. A method for manufacturing an electronic component-sealing product, the method comprising a step of performing insert molding with use of a first resin composition including the insert molding resin composition according to any one of claims 1 to 4, to form an electromagnetic wave-shielding layer on a surface of an electronic component.

13. The method according to claim 12, comprising a step of heating the first resin composition in an injection molding machine to make the first resin composition melted, and keeping the first resin composition stationary for 5 hours or more.

14. The method according to claim 12 or 13, comprising a step of performing insert molding with use of a second resin composition including a resin and an electromagnetic wave-shielding filler and having a lower concentration of the electromagnetic wave-shielding filler than a concentration of the electromagnetic wave-shielding filler in the first resin composition, to form a protection layer on the electromagnetic wave-shielding layer.
